# EUROPEAN PATENT SPECIFICATION

(11) **EP 1 774 069 B1**
(45) Date of publication and mention of the grant of the patent: **14.07.2010**
(21) Application number: 05728070.3
(22) Date of filing: 24.03.2005
(51) Int. Cl.: C30B 15/14, C30B 29/20

(54) **APPARATUS FOR GROWING SINGLE CRYSTALS FROM MELT**
VORRICHTUNG ZUM ZIEHEN VON EINKRISTALLEN AUS EINER SCHMELZE
APPAREIL DE FORMATION DE MONOCRISTAUX PAR FUSION

(30) Priority: 05.08.2004 RU 2004123876; 05.08.2004 RU 2004123875
(43) Date of publication of application: 18.04.2007
(73) Proprietor: Amosov, Vladimir Iljich, 124617 Moscow (RU); Pusch, Bernard, 12157 Berlin (DE)
(72) Inventor: AMOSOV, Vladimir, lljich, Moscow, 124617 (RU)
(74) Representative: Fischer, Uwe
(86) International application number: PCT/EP2005/003240
(87) International publication number: WO 2006/012925

(56) References cited:
- EP-A- 0 141 649
- FR-A- 2 122 768
- RU-C1- 2 222 644
- US-A- 4 863 554
- PATENT ABSTRACTS OF JAPAN vol. 016, no. 248 (M-1261), 5 June 1992 (1992-06-05) & JP 04 055687 A (TORU KATSUMATA; others: 01), 24 February 1992 (1992-02-24)

## Description

The present invention relates to devices for growing single crystals from a melt on a seed crystal and can be used in the technology of growing crystals, for instance, sapphire crystals, e.g. by the so called Amosov method.

The technical problem to be solved by the present invention is to provide an apparatus for growing large-size single crystals from a melt in a uniform thermal field with ruling out overcooling of the melt, and to provide structural perfection of crystals.

Known in the art is an apparatus for growing single-crystal bands of sapphire, comprising a chamber, a crucible, a thermal unit, a shaper unit, a seed holder mounted on a rod, all arranged inside the chamber.

The thermal unit is made as a cylindrical graphite heater, the inner surface of which is coated with a layer of silicon carbide, and screens.

The crucible for melt is coated from the outside with tungsten.

The crucible is mounted on a pedestal and arranged inside the graphite heater. The screens are disposed above the crucible (see USSR Inventor's Certificate No. 1213781, publ. 23.04.1991, C30B 15/34).

This apparatus has the following disadvantages.

The material of the heater is graphite with a spray-deposited layer of silicon carbide. This material reacts with aggressive aluminum oxides at high temperatures, the result being that the service life of the heater is sharply shortened and the growing crystal is contaminated with carbon. The heater is not subject to restoring in the case of breakage. The apparatus does not allow growing high-quality bulky single crystals.

Also known is an apparatus for growing single crystals, comprising a chamber, two melt heaters and a two-sectional crucible. In the upper section the starting material is melted with the help of one heater arranged around the upper section of the crucible, and growing is carried out from the lower section of the crucible with the help of another heater disposed under the lower section of the crucible (see USSR Inventor's Certificate No. 6761966, publ. 30.03.80, C30B 15/02).

This apparatus does not ensure growing bulky single crystals, because a directed removal of heat through the center of the melt cannot be created in the melt when enlarging a single crystal.

US-A-4 863 554 teaches a crystal pulling apparatus with a heater divided into at least two heaters.

Also known is an apparatus for growing single crystals from a melt, comprising a crucible, a heater inside which the crucible is mounted, and a system of heat shields, one of which is shaped as a truncated cone or a cylinder and surrounds the crystal in the region of the melt surface and the crystal interface; another heat shield precludes the passage of thermal radiations from the side surface of the crystal into the upper portion of the chamber (see US Patent No. 6338757, publ. 2002, National Patent Classification 117-218)

The apparatus has the following disadvantages. The system of heat shields is complicated and conservative. The temperature gradient cannot be controlled.

Likewise known is an apparatus for growing single crystals from a melt on a seed crystal, comprising a cylindrical chamber with a cover, a thermal unit, a crucible for the melt, a seed holder secured on a rod. The chamber is made two-sectional, the thermal unit is installed in the lower section of the chamber and consists of a heater assembled from U-shaped lamels, bent to repeat the shape of the crucible, closed annular water-cooled current lead-ins provided with openings in which free ends of the lamels are secured. And the U-shaped bent ends of the lamels are secured on a ring centering them. The current lead-ins are mounted on insulators which center the heater, and their lead-outs are disposed on the side surface of the cylinder in different horizontal planes. The current lead-ins are arranged either coaxially or one above the other. The lamels have the same length and configuration and are assembled into as circle. The centering ring which clamps together the bent U-shaped ends of the lamels does not take part in the electric circuit (see RU 2222644, C03B 15/00, 15/34, published in the Bulletin of Inventions, No. 3, 2004).

This prior art arrangement is adopted as the prototype.

The essence of the prior art arrangement adopted as the prototype consists in the design of the thermal unit, all the members of which, namely, the heater, current lead-ins, insulators, are compact and constitute an integral whole.

The design of the thermal unit offers a number of advantages.

The heater assembled of lamels secured on closed current lead-ins and on the centering ring simultaneously functions as a thermal shaper unit, it is capable of varying the configuration of the crystals being grown. The heater is simple in service, it can be easily assembled and disassembled when varying the single crystal configuration, because variation of the shapes of radial isotherms is accomplished by removing or adding the required number of lamels in the sections.

The design of the thermal unit essentially prolongs its service life and is ergonomic.

The known apparatus substantially improves the quality of dingle crystals grown by the conventional method, when the process of growing is carried with the removal of the crystallization heat either by reducing the rate of growing or by lowering the supply of power to the heater in the zone of the melt, thereby lowering the temperature of the heater. Both of these techniques adversely tell on the process, either reducing its efficiency or increasing the melt overcooling at the crystallization front, which brings about formation of structural defects (low-angle boundaries, polycrystalline structure).

The invention concerns an apparatus as set forth in claim 1.

The technical result of the claimed invention is the possibility of growing large-size single crystals by the Amosov method, enhancing the structural perfection owing to the absence of the melt overcooling, increasing the service life of the units.

The technical result is attained by that in the apparatus for growing single crystals - e. g. by the Amosov method -, which apparatus comprises a two-sectional chamber, a seed holder secured on a rod, a crucible, a thermal unit with a heater assembled from U-shaped lamels, bent to repeat the shape of the crucible, a centering ring on which closed portions of the lamels are secured, water-cooled annular current lead-ins, wherein, according to the invention, the thermal unit is made as two heaters similar in the shape, weight and dimensions, which are mirror images of each other, the horizontal portions of the U-shaped lamels, secured on the centering ring are turned through 90°, the rod with the seed holder are disposed inside the upper heater, the free ends of the lamels are connected to the current lead-ins with the current load signs ++ - - alternating, the crucible is mounted on insulated supports disposed between the heater lamels having the same current load sign, the free ends of the lamels are connected to the current lead-ins through current-conducting adapters made from a refractory material whose resistance is smaller than that of the lamels, the ends of the adapters connected to the lamels being located at the same distance from the heater axis, the lamels being made from refractory metals and their alloys such as tungsten, molybdenum, tantalum, graphite, silicon carbide; the current lead-ins are disposed inside the sections of the chamber so that the current lead-ins of the upper heater and the current lead-ins of the lower heater are located at the same distance from the jointing plane of the upper and lower sections of the chamber.

Growing crystals from melt by the Amosov method (e.g.) rules out the origination of the melt overcooling, because the crystallization heat is removed at the expense of increasing the axial temperature gradient in the zone of growing crystal from its minimal value. The axial gradient is regulated by varying the temperature of the thermal zone above the melt within the entire reaction volume in which the rod with the seed holder and the growing crystal is disposed, with decreasing and at the same time preserving the same temperature of the melt over the entire volume of the crucible. As a result, the removal of heat always proceeds through the center of the melt in the direction of the growing crystal, the origination of the melt overcooling being thus ruled out.

The essence of the claimed apparatus consists in a novel design of the thermal unit, which comprises two heaters similar in the shape, weight and design, arranged to form a mirror image of each other and constituting a united thermal area, in which the rod with the seed holder and the growing crystal are located on one side, and the crucible with the melt are located on the other side. The design of the heaters and their position with respect to each other make it possible to grow the crystal in a principally different manner. The novelty is that growing is effected not from the "overcooled" melt as in the prototype, but from the "overheated" melt.

Another advantage of the proposed design of the apparatus is the new embodiment of the heaters as such.

The novelty is that the horizontal portions of the bent U-shaped ends of the lamels are turned through 90°. This makes it possible to diminish substantially the diameter of the ring on which the U-shaped ends of the lamels are secured, and, correspondingly, to diminish the non-heated area of the crucible. One of the conditions for carrying out the process of growing single crystals by the Amosov method is the elimination of local overheating of the melt and maintenance of homogeneous temperature in the entire volume of the melt.

The above-indicated design feature is directed to ensuring this requirement.

Coupling the lamels to the current load with alternation of the load signs ++ -- allows transferring the crucible support from the rod in the center of the crucible and arrange them between the lamels bearing the same sign uniformly along the periphery of the crucible closer to the heater. This is of particular importance when growing large-size single crystals from large-diameter crucibles, because at the temperature of 2000°C the bottom of the crucible made from tungsten becomes deformed.

In the claimed design the total and uniformly distributed area of the supports is essentially larger than the area of one central support of the crucible. This increases the service life of the crucible and of the apparatus as a whole.

In the claimed apparatus water-cooled current lead-ins are arranged either coaxially or one above the other. In either of these variants vertically located portions (branches) of the lamels have different length. The minimal difference in the size is equal to the distance between the opposite-polarity current lead-in buses.

The difference in the length of the branches of the lamels leads to differences in their resistance, and with definite overall dimensions of the apparatus this difference becomes essential, and, hence, leads to non-homogeneous temperature characteristics of the thermal field. To eliminate this disadvantage, it is proposed to connect the free ends of the lamels to the current lead-ins via adapters made from a current-conducting material whose resistance is smaller than the resistance of the material of the lamels.

For providing homogeneity of the thermal field, all the points of connection of the ends of the lamels with the adapters are disposed at the same distance from the axis of the heater. This condition can be fulfilled by adjusting the length of the adapters: the farther the current-conducting bus from the center of the heater, the longer the adapter. The resistance of the adapter in this case can be neglected.

Using low-resistance adapters makes it possible to obviate deformation of the lamels directly at the annular water-cooled current lead-ins, i.e., increases their service life.

The presence of adapters makes it possible to adjust the diameter of the heater, and, hence, to use crucibles of different diameter.

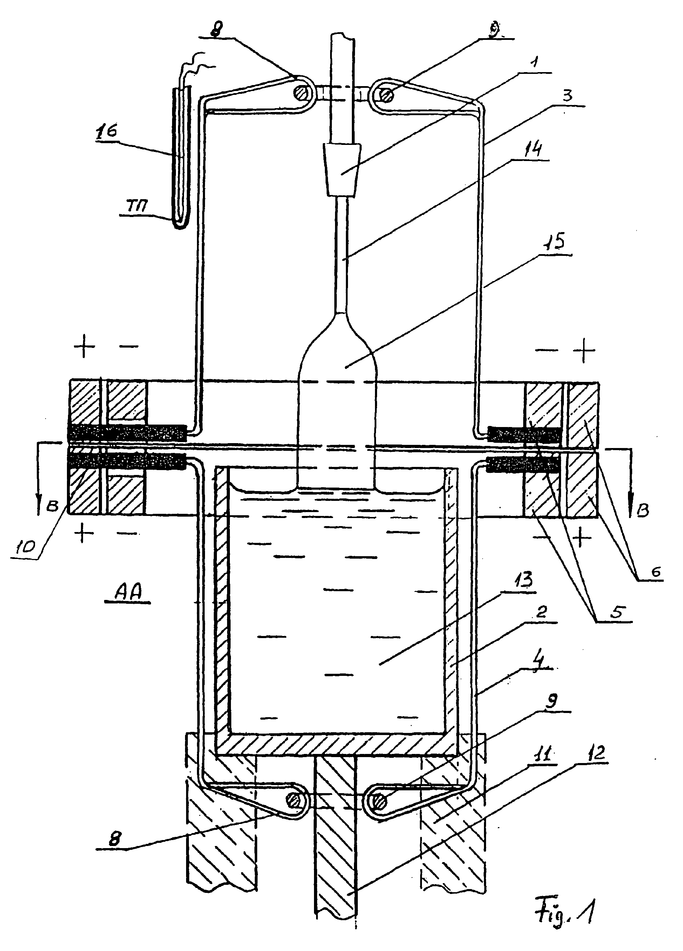

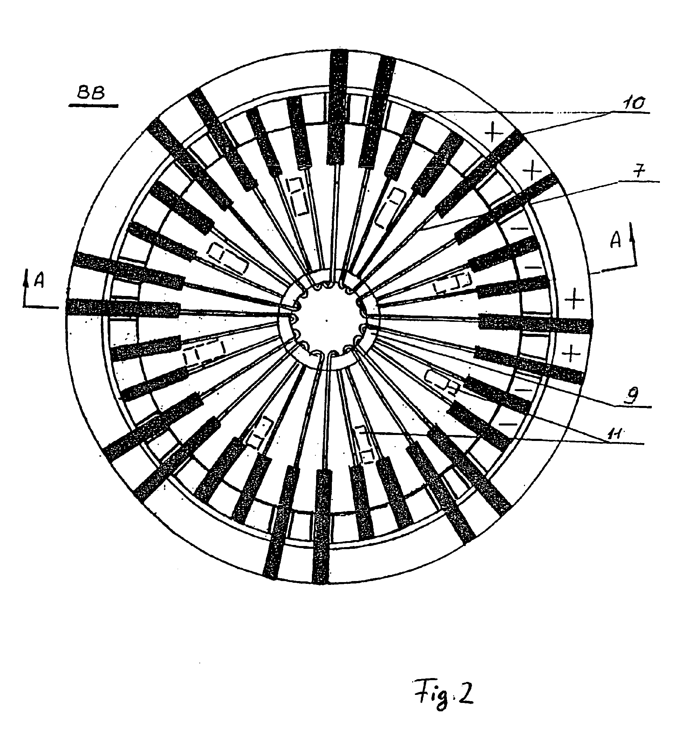

The apparatus is shown diagrammatically in Figs. 1 and 2.

View AA is an axial section, view BB is a horizontal section.

The apparatus consists of a two-sectional chamber (not shown in the Figure), a rod with a seed holder 1, a crucible 2, an upper heater 3, a lower heater 4, current lead-ins 5, 6 (an internal lead-in and an external lead-in, for the heaters 3 and 4, respectively), branches 7 of lamels of the heaters 3, 4, horizontal U-shaped portions 8 of the lamels being turned through 90° and secured, respectively, on rings 9. Vertical portions of the branches 7 are connected via adapters 10 with the water-cooled current lead-ins 5, 6. The crucible 2 is mounted on supports 11 located between the lamels nearer to the walls of the crucible 2 and one support 12 in the center of the crucible bottom. All the supports are electrically insulated from the chamber.

Shown in Figure 1 are a melt 13, a seed crystal 14 and a crystal 15 being grown.

For controlling the temperature of the upper heater 3 a thermocouple 16 is installed.

The apparatus operates in the following manner.

The lower heater 4 into which the crucible 2 with a charge is placed, is installed into the lower section of the chamber. The heater 3, inside which the rod with the seed holder 1 and with the seed crystal 14 are arranged, is installed in the upper section of the chamber. The chamber is evacuated, and heating of the charge is started by supplying to the upper heater 30-50% of the power required for complete melting of the charge. Then the temperature of the upper heater 3 is stabilized in accordance with the thermocouple voltage readings, and the rest of the power is supplied to the lower heater 4. The charge melting and the temperature stabilization in the thermal region constituted by the two heaters 3, 4 having been accomplished, the process is started. After carrying out the seeding stage, the single crystal enlargement is started.

The process of enlargement to a prescribed diameter and subsequent growing of the crystal are carried out by controlled lowering of the temperature of the upper heater till complete depletion of the melt, the power supplied to the lower heater being maintained constant throughout the process of growing.

On completion of the growing, the resulting crystal is cooled under isothermal conditions for precluding the formation of thermal stresses in the crystal. For this to be done, the loading of the lower heater is gradually lowered until the temperature in the lower section of the chamber becomes equal to the temperature in the upper section.

So, the claimed apparatus for growing single crystals from a melt by the Amosov method makes it possible to realize the process of growing single crystals from "overheated" melts, which rules out the origination of structural defects associated with the effect of overcooling at the "melt-crystal" interface. The apparatus provides essential increase of the service life of the main units: the lamels of the crucible heaters. Besides, the design of the thermal unit makes it possible to grow bulky single crystals of different diameter without modifying the whole apparatus.

## Claims

1. An apparatus for growing single crystals, comprising a two-sectional chamber, a seed holder (1) secured on a rod, a crucible (2), a thermal unit (3, 4) with a heater assembled from U-shaped lamels, bent to repeat the shape of the crucible, a centering ring (9) on which closed portions of the lamels are secured, water-cooled annular current lead-ins, **characterized in that** the thermal unit is made as two heaters (3, 4) similar in the shape, weight and dimensions, which are mirror images of each other, the horizontal portions of the U-shaped lamels, secured on the centering ring are turned through 90°, the rod with the seed holder are disposed inside the upper heater, the free ends of the lamels are connected to the current lead-ins (5, 6) with the current load signs ++ - - alternating, the crucible is mounted on insulated supports (11) disposed between the heater lamels having the same current load sign, the free ends of the lamels are connected to the current lead-ins through current-conducting adapters (10) made from a refractory material whose resistance is smaller than that of the lamels, the ends of the adapters connected to the lamels being located at the same distance from the heater axis.

2. An apparatus according to claim 1, **characterized in that** the lamels are made from rare refractory metals and alloys thereof.

3. An apparatus according to claim 2, **characterized in that** the lamels are made from tungsten, molybdenum.

4. An apparatus according to claim 2, **characterized in that** the lamels are made from tantalum.

5. An apparatus according to claim 1, **characterized in that** the lamels are made from graphite, silicon carbide.

6. An apparatus according to any one of claims 1, 2, 3, **characterized in that** the current lead-ins are current lead-ins of the lower heater are located at the same distance from the jointing plane of the upper and lower sections of the chamber.

7. An apparatus according to any of the preceding claims, **characterized in that** the apparatus is made for carrying out the Amosov method.

## Patentansprüche

1. Vorrichtung zum Ziehen von Einkristallen, umfassend eine Kammer mit zwei Sektionen, einem an einem Stabbefestigten Keimhalter (1), einem Tiegel (2), einer Thermoeinheit (3, 4) mit einer Heizvorrichtung, die aus U-förmigen Lamellen zusammengebaut und so gebogen ist, daß sie die Gestalt des Tiegels wiederholt, einem Zentrierungsring (9), auf dem geschlossene Abschnitte der Lamellen befestigt sind, wassergekühlten ringförmigen Stromeinführungen, **dadurch gekennzeichnet, daß** die Thermoeinheit als zwei Heizvorrichtungen (3, 4) ausgeführt ist, die hinsichtlich Gestalt, Gewicht und Abmessungen ähnlich sind, die Spiegelbilder voneinander sind, wobei die horizontalen Abschnitte der U-förmigen Lamellen, an dem Zentrierungsring befestigt, durch 90° gedreht sind, der Stab mit dem Keimhalter in der oberen Heizvorrichtung angeordnet sind, die freien Enden der Lamellen mit den Stromeinführungen (5, 6) verbunden sind, wobei die Stromlastzeichen ++ -- alternieren, wobei der Tiegel auf isolierten Stützen (11) montiert ist, die zwischen den Heizvorrichtungslamellen mit dem gleichen Stromlastzeichen angeordnet sind, wobei die freien Enden der Lamellen durch stromführende Adapter (10), die aus einem feuerfesten Material hergestellt sind, dessen Widerstand kleiner ist als der der Lamellen, mit den Stromeinführungen verbunden sind, wobei die Enden der Adapter, die mit den Lamellen verbunden sind, sich im gleichen Abstand von der Heizvorrichtungsachse befinden.

2. Vorrichtung nach Anspruch 1, **dadurch gekennzeichnet, daß** die Lamellen aus seltenen feuerfesten Metallen und Legierungen davon hergestellt sind.

3. Vorrichtung nach Anspruch 2, **dadurch gekennzeichnet, daß** die Lamellen aus Wolfram und Molybdän hergestellt sind.

4. Vorrichtung nach Anspruch 2, **dadurch gekennzeichnet, daß** die Lamellen aus Tantal hergestellt sind.

5. Vorrichtung nach Anspruch 1, **dadurch gekennzeichnet, daß** die Lamellen aus Graphit und Siliziumcarbid hergestellt sind.

6. Vorrichtung nach einem der Ansprüche 1, 2, 3, **dadurch gekennzeichnet, daß** die Stromeinführungen der unteren Heizvorrichtung im gleichen Abstand zu der Verbindungsebene der oberen und unteren Sektion der Kammer angeordnet sind.

7. Vorrichtung nach einem der vorhergehenden Ansprüche, **dadurch gekennzeichnet, daß** die Vorrichtung zum Ausführen des Amosov-Verfahrens hergestellt ist.

## Revendications

1. Appareil pour faire croître des monocristaux, comprenant une chambre en deux parties, un support de germe (1) fixé sur une tige, un creuset (2), une unité thermique (3, 4) avec des réchauffeurs assemblés à partir de lamelles en forme de U, pliée pour reproduire la forme du creuset, une bague de centrage (9) sur laquelle sont fixées des parties fermées des lamelles, des amenées de courant annulaires refroidies à l'eau, **caractérisé en ce que** l'unité thermique est fabriquée comme deux réchauffeurs (3, 4) de forme, poids et dimensions similaires, qui sont des images miroirs l'un de l'autre, les parties horizontales des lamelles en forme de U, fixées sur la bague de centrage, sont tournées de 90°, la tige avec le support de germe est disposée à l'intérieur du réchauffeur supérieur, les extrémités libres des lamelles sont reliées aux amenées de courant (5, 6) avec les signes de charge de courant ++ -- alternant, le creuset est monté sur des supports isolés (11) disposés entre les lamelles de réchauffeur ayant le même signe de charge de courant, et les extrémités libres des lamelles sont reliées aux amenées de courant par des adaptateurs conducteurs de courant (10) fabriqués dans un matériau réfractaire dont la résistance est inférieure à celle des lamelles, les extrémités des adaptateurs reliées aux lamelles se situant à la même distance de l'axe des réchauffeurs.

2. Appareil selon la revendication 1, **caractérisé en ce que** les lamelles sont fabriquées à partir de métaux réfractaires rares et d'alliages de ceux-ci.

3. Appareil selon la revendication 2, **caractérisé en ce que** les lamelles sont fabriquées à partir de tungstène, molybdène.

4. Appareil selon la revendication 2, **caractérisé en ce que** les lamelles sont fabriquées à partir de tantale.

5. Appareil selon la revendication 1, **caractérisé en ce que** les lamelles sont fabriquées à partir de graphite, carbure de silicium.

6. Appareil selon l'une quelconque des revendications 1, 2 et 3, **caractérisé en ce que** les amenées de courant du réchauffeur inférieur sont situées à la même distance de la plaque de jonction des parties supérieure et inférieure de la chambre.

7. Appareil selon l'une quelconque des revendications précédentes, **caractérisé en ce que** l'appareil est fabriqué pour mettre en oeuvre le procédé Amosov.
